(19)

Europäisches
Patentamt
European
Patent Office
Office européen
des brevets

(11) **EP 2 190 014 A1**

(12) **EUROPEAN PATENT APPLICATION**
published in accordance with Art. 153(4) EPC

(43) Date of publication:
**26.05.2010 Bulletin 2010/21**

(21) Application number: **08830793.9**

(22) Date of filing: **12.09.2008**

(51) Int Cl.:
**H01L 23/50** (2006.01)

(86) International application number:
**PCT/JP2008/066606**

(87) International publication number:
**WO 2009/035113 (19.03.2009 Gazette 2009/12)**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **13.09.2007   JP 2007238567**
**13.09.2007   JP 2007238568**

(71) Applicants:
• **Mitsui Mining & Smelting Co., Ltd**
**Tokyo 141-8584 (JP)**
• **Sun-a Corporation**
**Miyoshi-shi**
**Hiroshima 728-0006 (JP)**

(72) Inventors:
• **NAKAMURA, Toshimi**
**Ageo-shi**
**Saitama 362-0021 (JP)**
• **KAWANISHI, Toshiaki**
**Ageo-shi**
**Saitama 362-0021 (JP)**

• **HOSOI, Toshihiro**
**Ageo-shi**
**Saitama 362-0021 (JP)**
• **IZUTANI, Kenjiro**
**Ageo-shi**
**Saitama 362-0021 (JP)**
• **NAKAMURA, Hiroyuki**
**Miyoshi-shi**
**Hiroshima 728-0006 (JP)**
• **OSAWA, Yutaka**
**Miyoshi-shi**
**Hiroshima 728-0006 (JP)**
• **SUNADA, Hiroaki**
**Miyoshi-shi**
**Hiroshima 728-0006 (JP)**
• **TAKAHASHI, Tetsuyasu**
**Miyoshi-shi**
**Hiroshima 728-0006 (JP)**

(74) Representative: **Gardiner, Stephen Robin**
**Dehns**
**St Bride's House**
**10 Salisbury Square**
**London EC4Y 8JD (GB)**

(54) **LEAD FRAME AND LEAD FRAME MANUFACTURING METHOD**

(57)     [Problem] It is an object to provide a lead frame, an electronic device provided with a lead frame, a method of producing a lead frame, and a method of producing an electronic device provided with a lead frame that has been produced by the method of producing a lead frame, in which a lead frame is not corroded, a mechanical strength of the lead frame is not lowered, it is not necessary to carry out the conventional plating processing steps composed of two stages, the processes are simple, a cost is lower, and a large amount of waste liquid such as plating processing liquid is not generated, thereby preventing an environment from being affected.

[Means for Resolution] A lead frame comprises an outer lead part and an inner lead part, and a plating is carried out to at least a part of at least any one of the outer lead part and the inner lead part.

[Fig. 2]

**Description**

TECHNICAL FIELD

The present invention relates to a lead frame that is used for an electronic device such as a sensor and a semiconductor device that are used for carrying out a fluid discrimination, an electronic device provided with a lead frame, a method of producing a lead frame, and a method of producing an electronic device provided with a lead frame that has been produced by the method of producing a lead frame.

BACKGROUND ART

For instance, Patent document 1 (Japanese Patent Application Laid-Open Publication No. 11-153561), Patent document 2 (Japanese Patent Application Laid-Open Publication No. 2006-29956) and Patent document 3 (Japanese Patent Application Laid-Open Publication No. 2005-337969) have proposed a thermal type sensor that is used for a fluid discrimination apparatus that carries out a discrimination such as a fluid type discrimination, a concentration discrimination, the existence or nonexistence discrimination of a fluid, a temperature discrimination of a fluid, a flow rate discrimination, and a fluid level discrimination for a fluid to be discriminated by utilizing a thermal property of a fluid for a fluid such as a hydrocarbon series liquid such as a gasoline, a naphtha, a kerosene, a light oil, and a heavy oil, and an alcohol series liquid such as ethanol and methanol, a urea aqueous solution liquid, a gas, and a particulate.

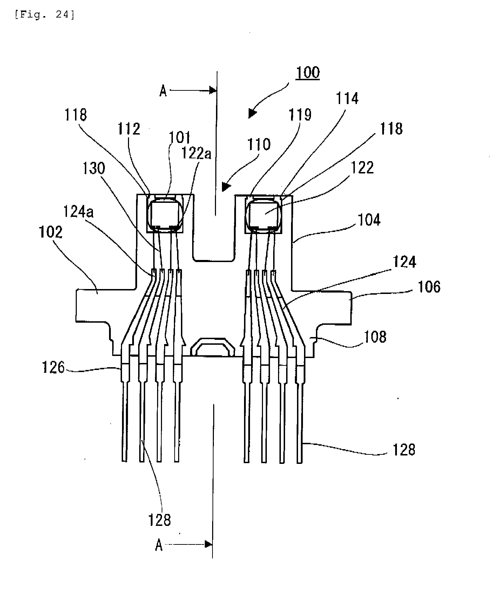

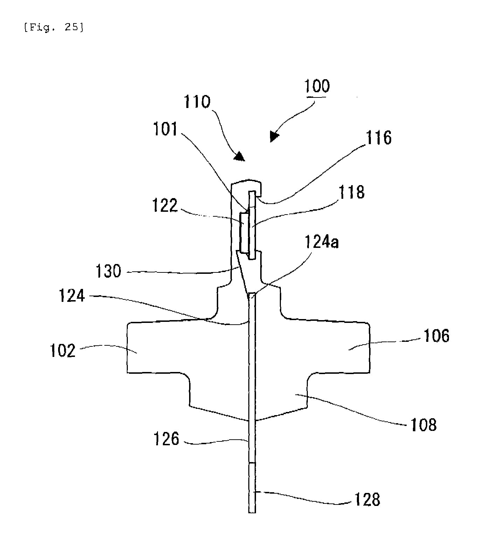

As shown in Figs. 24 and 25, a thermal type sensor 100 is provided with a sensor body 104 made of a mold resin 102, and the sensor body 104 is provided with a flange part 106 in a generally elliptical shape, a rear face protrusion part 108 that is protruded on a rear face of the flange part 106, and a detecting part 110 that is protruded on a surface of the flange part 106.

The detecting part 110 is composed of a pair of a fluid discrimination detecting part 112 and a fluid temperature detecting part 114 in a rectangular flat plate shape that are disposed apart at a regular interval. The fluid discrimination detecting part 112 and the fluid temperature detecting part 114 have the same structure basically, and are provided with an electrical heating element and a temperature sensing element. For the fluid temperature detecting part 114, an electrical heating element is not operated but only a temperature sensing element is operated.

As shown in Figs. 24 and 25, the fluid discrimination detecting part 112 and the fluid temperature detecting part 114 are provided with a metal die pad 118 that functions as a heat transfer member that is disposed in the sensor body 104 in such a manner that a part of the metal die pad 118 is exposed to an opening part 116 in which a mold resin 102 is missing. A thin film chip 122 is mounted to a mounting plane 120 on an opposite side of the opening part 116 of the die pad 118.

In the sensor body 104, a plurality of inner leads 124 are disposed in such a manner that the inner leads 124 and the metal die pad 118 thereof are disposed face to face, that the inner leads 124 are disposed apart from the metal die pad 118 at a regular interval, and that the inner leads 124 are separate from each other at a regular interval. An external connecting terminal 126 is disposed in an extending manner in a direction of the rear face protrusion part 108, and an outer lead 128 is formed at a leading end part of the external connecting terminal 126.

An electrode of the thin film chip 122 and an electrode 124a of the inner lead 124 are electrically connected to each other by a bonding wire 130 made of Au.

The thermal type sensor 100 configured as described above makes an electrical heating element to produce heat by a power distribution, and heats a temperature sensing element by the heat generation. The thermal type sensor 100 then gives a thermal influence by a fluid to be discriminated to a heat transfer from the electrical heating element to the temperature sensing element, and carries out a fluid discrimination as described above for a fluid to be discriminated based on an electrical output corresponded to an electrical resistance of the temperature sensing element.

Patent document 1: Japanese Patent Application Laid-Open Publication No. 11-153561
Patent document 2: Japanese Patent Application Laid-Open Publication No. 2006-29956
Patent document 3: Japanese Patent Application Laid-Open Publication No. 2005-337969

DISCLOSURE OF THE INVENTION

PROBLEMS TO BE SOLVED BY THE INVENTION

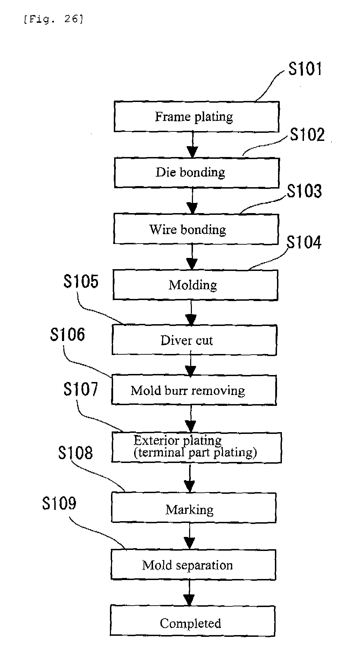

The conventional thermal type sensor 100 is produced in the following producing processes as shown in Fig. 26.

More specifically, the above described die pad 118, the inner lead 124, the external connecting terminal 126, and the outer lead 128 are formed in an integrating manner as a lead frame by using Cu, carbon steel, an aluminum alloy, or aluminum in the producing processes although it is not shown.

In the frame plating process of a step S101 at first, a Pd plating or an Au plating of a noble metal series, an Ni plating, an Sn plating, an Sn-Pb plating, an Sn-Bi plating, an Ag plating, an Ag-Cu plating, or an In plating of a solder series is applied to the entire surface of the lead frame formed in an integrating manner as described above for instance. In this case, a kind of a plate is not restricted in particular, and a noble metal and a plating metal that is used in soldering can be used.

After a plate processing is applied to the entire surface of the lead frame in the frame plating process of the step S101, the thin film chip 122 is mounted (bonded) to the die pad 118 via a jointing material 101 such as an adhesive in a die bond process of a step S102.

In a wire bonding process of a step S103 in the next place, an electrode of the thin film chip 122 and an electrode of the inner lead 124 are electrically connected to each other by a bonding wire 130 made of Au.

In this state, a lead frame is disposed in a metal mold, and a sensor body 104 made of a mold resin 102 is formed at the predetermined part of the lead frame by an injection molding in which an epoxy resin is injected in a mold process of a step S104.

After that, after the lead frame is separated into parts of a predetermined size in a diver cut process of a step S105, a so-called burr that is an excess resin part of the mold resin 102 of the sensor body 104 is removed by a dipping to an acid solution or an alkaline solution in a mold burr removing process of a step S106.

In an exterior plating (a terminal part plating) process of a step S107 in the next place, a Pd plating or an Au plating of a noble metal series, an Ni plating, an Sn plating, an Sn-Pb plating, an Sn-Bi plating, an Ag plating, an Ag-Cu plating, or an In plating of a solder series is applied to the outer lead 128 formed at a leading end part of the external connecting terminal 126 for instance to improve a soldering property in a soldering to an external lead wire. In this case, a kind of a plate is not restricted in particular, and a noble metal and a plating metal that is used in soldering can be used.

After a marking is carried out to a discriminable part such as a side part of the flange part 56 for the operation and maintenance control of a product in a marking process of a step S108, an unnecessary part of a lead frame is cut and removed from the sensor 100 and a shape of the outer lead 128 is arranged to obtain the sensor 100 that is a completed product in a mold separation process of a step S109.

However, since Cu is used as a material of a lead frame for the conventional sensor 100 described above, a corrosion resistant characteristic is deteriorated. The whole lead frame is dipped in a plating solution made of an acid solution or an alkaline solution in the frame plating process of the step S101. In addition, the whole lead frame is also dipped in a plating solution made of an acid solution or an alkaline solution in the mold burr removal process of the step S106 and in the exterior plating (a terminal part plating) process of the step S107. Consequently, the lead frame is corroded, thereby lowering a mechanical strength of the lead frame.

As described above, the plating processing steps composed of two steps of a plating processing to the entire surface of a lead frame in the frame plating process of the step S101 and the exterior plating (a terminal part plating) process of the step S107 must be carried out. Consequently, the steps are complex and difficult, and a cost becomes higher. In addition, a large amount of waste liquid such as plating processing liquid is generated, thereby causing concern over an influence to an environment.

Moreover, a migration occurs at the outer lead 128 formed at a leading end part of the external connecting terminal 126, thereby lowering a bonding strength of a soldering.

Moreover, a soft material such as Cu is used as a material of the lead frame in the mold process of the step S104. Consequently, the die pad 118 that is supported by the lead frame in a so-called cantilever state is deformed due to a resin pressure of a mold resin in an injection molding, thereby degrading a quality as a sensor and preventing an accurate fluid discrimination from being carried out in some cases.

Furthermore, for the conventional thermal type sensor 100, the metal die pad 118 is exposed to the opening part 116 in which the mold resin 102 is missing. Consequently, a fluid to be detected enters between the opening part 116 and the metal die pad 118, thereby preventing the thin film chip 122 from functioning correctly. In addition, the inner lead 124 and the bonding wire 130 are corroded, thereby lowering a quality as a sensor and preventing an accurate fluid discrimination from being carried out in some cases.

Since the opening part 116 is formed, the metal die pad 118 is exposed. In the case in which the die pad 118 is formed as a lead frame, the die pad 118 is formed in such a manner that the die pad 118 is supported from an upper section as shown in Fig. 24. Consequently, in the case in which the sensor 100 is used, a supporting part 119 of the die pad 118 is exposed for the detecting part 110 composed of the fluid discrimination detecting part 112 and the fluid temperature detecting part 114 that are parts that come into contact with a fluid to be discriminated.

As described above, in the case in which a part of the lead frame such as the die pad 118 and the supporting part 119 is exposed to a fluid to be discriminated, a fluid to be discriminated enters between the mold resin 102 and the lead frame, thereby preventing the thin film chip 122 from functioning correctly. In addition, the inner lead 124 and the bonding wire 130 are corroded, thereby lowering a quality as a sensor and preventing an accurate fluid discrimination from being carried out in some cases.

The present invention was made in consideration of such conditions, and an object of the present invention is to provide a lead frame, an electronic device provided with a lead frame, a method of producing a lead frame, and a method of producing an electronic device provided with a lead frame that has been produced by the method of producing a lead frame, in which a lead frame is not corroded, a mechanical strength of the lead frame is not lowered, it is not necessary to carry out the conventional plating processing steps composed of two stages, the processes are simple, a cost is lower, and a large amount of waste liquid such as plating processing liquid is not generated, thereby preventing an environment from being affected.

Moreover, another object of the present invention is to provide a lead frame, an electronic device provided with a lead frame, a method of producing a lead frame, and a method of producing an electronic device provided with a lead frame that has been produced by the method of producing a lead frame, in which a migration does not occur at a part of the outer lead formed at a leading end part of the external connecting terminal, thereby preventing a bonding strength of a soldering from being lowered, and the die pad that is supported by the lead frame in a so-called cantilever state is not deformed due to a resin pressure of a mold resin in an injection molding, thereby preventing a quality as a sensor from being degraded and causing an accurate fluid discrimination to be carried out.

Moreover, another object of the present invention is to provide a lead frame, an electronic device provided with a lead frame, a method of producing a lead frame, and a method of producing an electronic device provided with a lead frame that has been produced by the method of producing a lead frame, in which a fluid to be detected does not enter between the opening part 116 and the metal die pad 118 as formed conventionally, thereby preventing the thin film chip 122 from stopping a correct function, and the inner lead 124 and the bonding wire 130 are not corroded, thereby preventing a quality as a sensor from being lowered and causing an accurate fluid discrimination to be carried out.

Moreover, another object of the present invention is to provide a lead frame, an electronic device provided with a lead frame, a method of producing a lead frame, and a method of producing an electronic device provided with a lead frame that has been produced by the method of producing a lead frame, in which a fluid to be discriminated does not enter between the opening part 116 and the metal die pad 118 and between the supporting part 119 and the mold resin 102 as formed conventionally, thereby preventing the thin film chip 122 from stopping a correct function, and the inner lead 124 and the bonding wire 130 are not corroded, thereby preventing a quality as a sensor from being lowered and causing an accurate fluid discrimination to be carried out.

MEANS FOR SOLVING THE PROBLEMS

The present invention is made in order to solve the above problems of the conventional art. A lead frame in accordance with the present invention is characterized by comprising an outer lead part and an inner lead part, wherein a plating is carried out to at least a part of at least any one of the outer lead part and the inner lead part.

A method of producing a lead frame in accordance with the present invention is characterized by comprising an outer lead part and an inner lead part, wherein a plating is carried out to at least a part of at least any one of the outer lead part and the inner lead part.

By the above configuration, since a plating is carried out to at least a part of at least any one of the outer lead part and the inner lead part, it is not necessary to carry out the plating processing to the entire surface of a lead frame in the conventional way. Consequently, it is not necessary to carry out the conventional plating processing steps composed of two steps, the processes are simple, a cost is lower, and a large amount of waste liquid such as plating processing liquid is not generated due to a partial plating process, thereby preventing an environment from being affected.

Moreover, the lead frame in accordance with the present invention is **characterized in that** a plating is carried out to the outer lead part and the inner lead part as the whole of the lead frame, or a plating is carried out to the outer lead part after a plating is carried out to the inner lead part.

By the above configuration, since a plating is carried out to the outer lead part and the inner lead part as the whole of the lead frame, or a plating is carried out to the outer lead part after a plating is carried out to the inner lead part, it is not necessary to carry out the conventional plating processing steps composed of two stages, the processes are simple, a cost is lower, and a large amount of waste liquid such as plating processing liquid is not generated due to a partial plating process, thereby preventing an environment from being affected.

Moreover, the lead frame in accordance with the present invention is **characterized in that** the plate is made of at least one kind of a plating metal selected from Au, Ag, Pd, Ni, Sn, Cu, Bi, Sn-Bi, Sn-Ag, and Sn-Ag-Pb.

By the above configuration, since the plate is made of at least one kind of a plating metal selected from Au, Ag, Pd, Ni, Sn, Cu, Bi, Sn-Bi, Sn-Ag, and Sn-Ag-Pb, a migration does not occur at a part of the outer lead formed at a leading end part of the external connecting terminal unlike a conventional configuration, thereby preventing a bonding strength of a soldering from being lowered.

Moreover, the lead frame in accordance with the present invention is **characterized in that** the lead frame is made of a corrosion resisting metal.

By the above configuration, since the lead frame is made of a corrosion resisting metal, the lead frame is not corroded, and a mechanical strength of the lead frame is not lowered although the lead frame is dipped in an acid solution or an alkaline solution in the plating process.

Moreover, the lead frame in accordance with the present invention is **characterized in that** the lead frame is made of a hard metal having a material hardness Hv is at least 135.

By the above configuration, since the lead frame is made of a hard metal (a metal having rigidity (spring property)) having a material hardness Hv is at least 135, the die pad that is supported by the lead frame in a so-called cantilever state is not deformed due to a resin pressure of a mold resin in an injection molding, thereby preventing a quality as a sensor from being degraded and causing an accurate fluid discrimination to be carried out for instance.

Moreover, the lead frame in accordance with the present invention is **characterized in that** the lead frame is made of at least one kind of a metal selected from stainless steel and an Fe-Ni series alloy.

By the above configuration, since the lead frame is made of at least one kind of a metal selected from stainless steel and an Fe-Ni series alloy, the lead frame is not corroded, and a mechanical strength of the lead frame is not lowered although the lead frame is dipped in an acid solution or an alkaline solution in the plating process. In addition, the die pad that is supported by the lead frame in a so-called cantilever state is not deformed due to a resin pressure of a mold resin in an injection molding, thereby preventing a quality as a sensor from being degraded and causing an accurate fluid discrimination to be carried out for instance.

Moreover, the lead frame in accordance with the present invention is **characterized in that** the lead frame is provided with an electronic component mounting part that is used for mounting an electronic component.

By the above configuration, an electronic component such as a thin film chip and an IC can be mounted to an electronic component mounting part, and a device including the electronic component mounting part can be used as a sensor or a semiconductor device.

Moreover, the lead frame in accordance with the present invention is **characterized in that** the inner lead part and an electronic component mounted to the electronic component mounting part are electrically connected to each other.

By the above configuration, an electronic component such as a thin film chip and an IC can be mounted to an electronic component mounting part, the inner lead part and an electronic component mounted to the electronic component mounting part can be electrically connected to each other by wire bonding for instance, and a device including the electronic component mounting part can be used as a sensor or a semiconductor device.

Moreover, the lead frame in accordance with the present invention is **characterized in that** the inner lead part and an electronic component mounted to the electronic component mounting part are air-tightly sealed or sealed by a resin.

By the above configuration, since the inner lead part and an electronic component mounted to the electronic component mounting part are covered by a ceramic or a metal and are air-tightly sealed inside by inert gas, or are sealed by a resin (resin-molded) by a resin molding, a fluid to be detected does not enter, thereby preventing an electronic component such as a thin film chip from stopping a correct function, and the inner lead and the bonding wire are not corroded, thereby preventing a quality as a sensor from being lowered and causing an accurate fluid discrimination to be carried out for instance.

Moreover, a lead frame in accordance with the present invention is characterized by comprising an outer lead part, an inner lead part, and an electronic component mounting part that is used for mounting an electronic component, wherein a support lead part for supporting the electronic component mounting part is formed from the outer lead part side.

Moreover, a method of producing a lead frame in accordance with the present invention is characterized by comprising an outer lead part, an inner lead part, and an electronic component mounting part that is used for mounting an electronic component, wherein a support lead part for supporting the electronic component mounting part from the outer lead part side is formed in the electronic component mounting part.

By the above configuration, in the case in which the lead frame is adopted as a lead frame of a conventional thermal type sensor for instance, the lead frame is not exposed to the detecting part that is exposed to a fluid to be discriminated. Consequently, a fluid to be discriminated does not enter between the lead frame and the mold resin unlike the conventional sensor, thereby preventing the thin film chip 122 from stopping a correct function, and the inner lead 124 and the bonding wire 130 are not corroded, thereby preventing a quality as a sensor from being lowered and causing an accurate fluid discrimination to be carried out for instance.

Moreover, the lead frame in accordance with the present invention is characterized by comprising at least two support lead parts.

By the above configuration, the electronic component mounting part that is supported by the lead frame in a so-called cantilever state is not deformed due to a resin pressure of a mold resin in an injection molding, thereby preventing a quality as a sensor from being degraded and causing an accurate fluid discrimination to be carried out for instance.

Moreover, the lead frame in accordance with the present invention is **characterized in that** the inner lead part and an electronic component mounted to the electronic component mounting part are electrically connected to each other.

By the above configuration, an electronic component such as a thin film chip and an IC can be mounted to an electronic component mounting part, the inner lead part and an electronic component mounted to the electronic component mounting part can be electrically connected to each other by wire bonding for instance, and a device including the electronic component mounting part can be used as a sensor or a semiconductor device.

Moreover, the lead frame in accordance with the present invention is **characterized in that** the inner lead part, an electronic component mounted to the electronic component mounting part, and the support lead part are air-tightly sealed or sealed by a resin.

By the above configuration, since the inner lead part, an electronic component mounted to the electronic component mounting part, and the support lead part are covered by a ceramic or a metal and are air-tightly sealed inside by inert gas, or are sealed by a resin (resin-molded) by a resin molding, a fluid to be discriminated does not enter, thereby preventing an electronic component such as a thin film chip from stopping a correct function, and the inner lead and the bonding wire are not corroded, thereby preventing a quality as a sensor from being lowered and causing an accurate fluid discrimination to be carried out for instance.

Moreover, the lead frame in accordance with the present invention is **characterized in that** a lead frame part that is air-tightly sealed or sealed by a resin is not exposed for an exposure part that is exposed to an external environment in use in a part that is air-tightly sealed or sealed by a resin.

By the above configuration, in the case in which the lead frame is used as a lead frame of a sensor that carries out a fluid discrimination of a fluid to be discriminated for instance, the lead frame is not exposed to a fluid to be discriminated for the exposure part that is exposed to a fluid to be discriminated (an external environment). Consequently, a boundary phase between the lead frame and a resin mold is not exposed to a fluid to be discriminated, and a fluid to be discriminated does not enter between the lead frame and a resin mold. In addition, a fluid to be discriminated does not enter, thereby preventing an electronic component such as a thin film chip from stopping a correct function, and the inner lead and the bonding wire are not corroded, thereby preventing a quality as a sensor from being lowered and causing an accurate fluid discrimination to be carried out for instance.

Moreover, an electronic device in accordance with the present invention is characterized by comprising the lead frame as defined in any one of the above descriptions.

Moreover, the electronic device in accordance with the present invention is **characterized in that** the electronic device is a sensor that is used for carrying out a fluid discrimination.

Moreover, the electronic device in accordance with the present invention is **characterized in that** the exposure part is exposed to a fluid in the fluid discrimination.

Moreover, the electronic device in accordance with the present invention is **characterized in that** the fluid discrimination is at least one discrimination of the fluid type discrimination, a concentration discrimination, the fluid existence or nonexistence discrimination, a fluid temperature discrimination, a flow rate discrimination, a fluid leakage discrimination, and a fluid level discrimination.

By the above configuration, for a fluid such as a hydrocarbon liquid such as a gasoline, a naphtha, a kerosene, a light oil, and a heavy oil, and an alcohol liquid such as ethanol and methanol, and a fluid such as a urea aqueous solution liquid, a gas, and a particulate, it is possible to carry out a fluid discrimination such as the fluid type discrimination, a concentration discrimination, the fluid existence or nonexistence discrimination, a fluid temperature discrimination, a flow rate discrimination, and a fluid level discrimination for a fluid to be discriminated by using the physical properties of a fluid, for instance the thermal properties of a fluid.

By the above configuration, in the case in which a fluid discrimination is carried out, the lead frame that is airtightly sealed or sealed by a resin is not exposed to a fluid for the exposure part that is exposed to a fluid. Consequently, a fluid to be discriminated does not enter between the lead frame and a resin mold, thereby preventing an electronic component such as a thin film chip from stopping a correct function, and the inner lead and the bonding wire are not corroded, thereby preventing a quality as a sensor from being lowered and causing an accurate fluid discrimination to be carried out for instance.

EFFECT OF THE INVENTION

By the present invention, since a plating is carried out to at least a part of at least any one of the outer lead part and the inner lead part, it is not necessary to carry out the plating processing to the entire surface of a lead frame in the conventional way. Consequently, it is not necessary to carry out the conventional plating processing steps composed of two steps, the processes are simple, a cost is lower, and a large amount of waste liquid such as plating processing liquid is not generated due to a partial plating process, thereby preventing an environment from being affected.

Moreover, by the present invention, since a plating is carried out to the outer lead part and the inner lead part as the whole of the lead frame, or a plating is carried out to the outer lead part after a plating is carried out to the inner lead part, it is not necessary to carry out the conventional plating processing steps composed of two stages, the processes are simple, a cost is lower, and a large amount of waste liquid such as plating processing liquid is not generated due to a partial plating process, thereby preventing an environment from being affected.

Moreover, by the present invention, since the plate is made of at least one kind of a plating metal selected from Au, Ag, Pd, Ni, Sn, Cu, Bi, Sn-Bi, Sn-Ag, and Sn-Ag-Pb, a migration does not occur at a part of the outer lead formed at a leading end part of the external connecting terminal unlike a conventional configuration, thereby preventing a bonding strength of a soldering from being lowered.

Moreover, by the present invention, since the lead frame is made of a corrosion resisting metal, the lead frame is not corroded, and a mechanical strength of the lead frame is not lowered although the lead frame is dipped in an acid solution or an alkaline solution in the plating process.

Moreover, by the present invention, since the lead frame is made of a hard metal (a metal having rigidity (spring property)) having a material hardness Hv is at least 135, the die pad that is supported by the lead frame in a so-called cantilever state is not deformed due to a resin pressure of a mold resin in an injection molding, thereby preventing a quality as a sensor from being degraded and causing an accurate fluid discrimination to be carried out for instance.

Moreover, by the present invention, since the lead frame is made of at least one kind of a metal selected from stainless steel and an Fe-Ni series alloy, the lead frame is not corroded, and a mechanical strength of the lead frame is not lowered although the lead frame is dipped in an acid solution or an alkaline solution in the plating process. In addition, the die pad that is supported by the lead frame in a so-called cantilever state is not deformed due to a resin pressure of a mold resin in an injection molding, thereby preventing a quality as a sensor from being degraded and causing an accurate fluid discrimination to be carried out for instance.

By the above configuration, for a fluid such as a hydrocarbon liquid such as a gasoline, a naphtha, a kerosene, a light oil, and a heavy oil, and an alcohol liquid such as ethanol and methanol, and a fluid such as a urea aqueous solution liquid, a gas, and a particulate, it is possible to carry out a fluid discrimination such as the fluid type discrimination, a concentration discrimination, the fluid existence or nonexistence discrimination, a fluid temperature discrimination, a flow rate discrimination, and a fluid level discrimination for a fluid to be discriminated by using the physical properties of a fluid, for instance the thermal properties of a fluid.

Moreover, by the present invention, since a support lead part for supporting the die pad is formed from the outer lead part side, in the case in which a device is used as a conventional sensor in which a lead frame is molded by a resin, a part of the lead frame is not exposed to an external environment (a fluid to be discriminated). Consequently, a fluid to be discriminated does not enter between the lead frame and a resin mold, thereby preventing a thin film chip from stopping a correct function, and an inner lead and a bonding wire are not corroded, thereby preventing a quality as a sensor from being lowered.

BRIEF DESCRIPTION OF THE DRAWINGS

Fig. 1 is a top view showing a multi-cavity lead frame in ) accordance with an embodiment of the present invention.

Fig. 2 is a partially enlarged top view showing the lead frame of Fig. 1.

Fig. 3 is a schematic process drawing illustrating a production process of a thermal type sensor in which the lead frame of Fig. 1 is used.

Fig. 4 is a partially enlarged top view showing the lead frame of Fig. 1 for illustrating a production process of a thermal type sensor in which the lead frame of Fig. 1 is used.

Fig. 5 is a perspective view showing a thermal type sensor in which the lead frame of Fig. 1 is used.

Fig. 6 is a vertical cross-sectional view showing the thermal type sensor of Fig. 5.

Fig. 7 is a vertical cross-sectional view taken along the line A-A for the thermal type sensor of Fig. 6.

Fig. 8 is a schematic view illustrating a mold process.

Fig. 9 is a graph showing a result of Fig. 8 and showing a relationship between a frame material spring property and a floppy property.

Fig. 10 is a graph showing a comparison of an operating time and a change of a concentration error in the case in which a conventional thermal type sensor in which a lead frame is used and a thermal type sensor in which the lead frame in accordance with the present invention is used are used as a concentration sensor of liquid. Fig. 10(a) is a graph in the case in which a thermal type sensor with a conventional lead frame is used. Fig. 10(b) is a graph in the case in which a thermal type sensor with a lead frame in accordance with the present invention is used.

Fig. 11 is an ultrasonic transmission image view for using the ultrasonic test equipment for illustrating a change of a state inside the sensor related to the time course in a state in which a sensor having a configuration in which a conventional lead frame is exposed to a fluid to be discriminated and a sensor in accordance with the present invention are in water.

Fig. 12 is an exploded perspective view showing an embodiment in which a sensor 50 in accordance with the present invention is applied to a fluid discrimination apparatus.

Fig. 13 is a partial cross-sectional view of Fig. 10. Fig. 14 is a view showing a mounting state of a fluid discrimination apparatus in accordance with the present invention to a tank.

Fig. 15 is a circuit block diagram for discriminating a kind of a fluid.

Fig. 16 is a view showing a relationship between a single pulse voltage P that is applied to an electrical heating element and a sensor output Q.

Fig. 17 is a view illustrating that there is a fluid kind corresponded first voltage value of a sugar aqueous solution having a sugar concentration in some range in a range of the fluid kind corresponded first voltage value V01 that is obtained by a urea aqueous solution having a urea concentration in the predetermined range.

Fig. 18 is a view showing that the fluid kind corresponded first voltage value V01 and the fluid kind corresponded second voltage value V02 for a urea aqueous solution, a sugar aqueous solution, and water as a relative value in the case in which the fluid kind corresponded first voltage value V01 and the fluid kind corresponded second voltage value V02 of a urea aqueous solution having a urea concentration of 30% are 1.000.

Fig. 19 is a view showing an example of a first calibration curve.

Fig. 20 is a view showing an example of a second calibration curve.

Fig. 21 is a view showing an example of a liquid temperature corresponded output value T.

Fig. 22 is a graph schematically illustrating that acceptance criteria for discriminating a predetermined fluid in accordance with a combination of the fluid kind corresponded first voltage value V01 and the fluid kind corresponded second voltage value V02 vary depending on a temperature.

Fig. 23 is a flow chart showing a discrimination process of a kind of a fluid.

Fig. 24 is a vertical cross-sectional view showing a conventional thermal type sensor.

Fig. 25 is a vertical cross-sectional view taken along the line A-A for the conventional thermal type sensor.

Fig. 26 is a schematic process drawing illustrating a production process of a thermal type sensor in which the conventional lead frame is used.

Fig. 27 is a graph illustrating a concentration discrimination error of a thermal type sensor in which a lead frame material in accordance with the present invention is used and a thermal type sensor in which a conventional lead frame material is used.

EXPLANATIONS OF LETTERS OR NUMERALS

1: Lead frame body
2: Lead frame
3: Positioning hole
4: Outer frame body
6: Lower frame body
8: Outer lead
10: External connecting terminal
12: Left frame body
14: Right frame body
16: Horizontal supporting part
18: Left center supporting part
20: Right center supporting part
20A: Container body
22: Inner lead
24: Inner lead leading end part
24a: Electrode part
28: Right hanging lead
30: Left center hanging lead
32: Right center hanging lead
34: Die pad
36: Supporting projection part
38: Jointing material
40: Thin film chip
42: Bonding wire
44: Mold resin
46: Separate part
48: Lead frame
50: Sensor
54: Sensor body
56: Flange part

58: Rear face protrusion part
60: Detecting part
62: Fluid discrimination detecting part
62a2: Temperature sensing element
62a4: Electrical heating element
64: Fluid temperature detecting part
64a2: Temperature sensing element
66: Tank
68: Opening part
70: Fluid discrimination apparatus
72: Inlet pipe
74: Outlet pipe
76: Pump
78: Fluid discrimination sensor part
80: Supporting part
82: Attachment part
86: Switch
88: Resistive element
90: Resistive element
91: Microcomputer
92: Differential amplifier
93: Output buffer circuit
94: Fluid temperature detecting amplifier
96: Measured fluid introduction path
98: Cover material
100: Sensor
101: Jointing material
102: Mold resin
104: Sensor body
106: Flange part
108: Rear face protrusion part
110: Detecting part
112: Fluid discrimination detecting part
114: Fluid temperature detecting part
116: Opening part
118: Die pad
119: Supporting part
120: Mounting plane
122: Thin film chip
124: Inner lead
124a: Electrode
126: External connecting terminal
128: Outer lead
130: Bonding wire

BEST MODE OF CARRYING OUT THE INVENTION

An embodiment (example) of the present invention will be described below in detail with reference to the drawings.

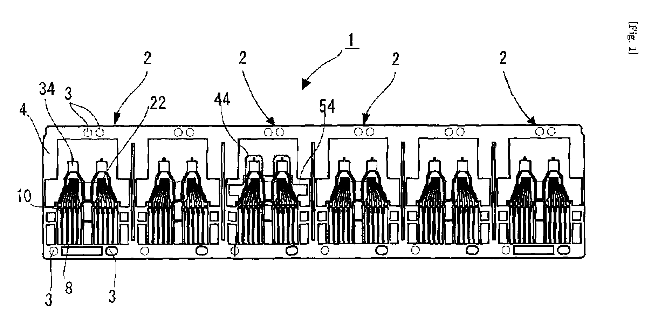

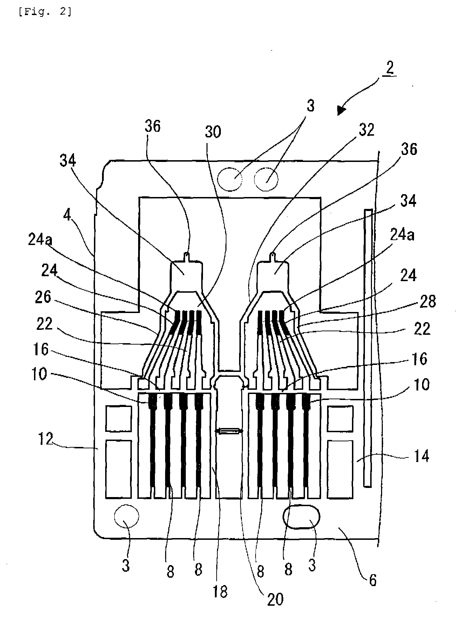

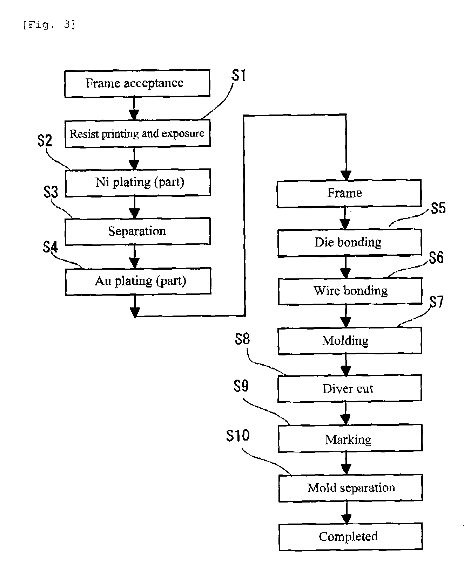

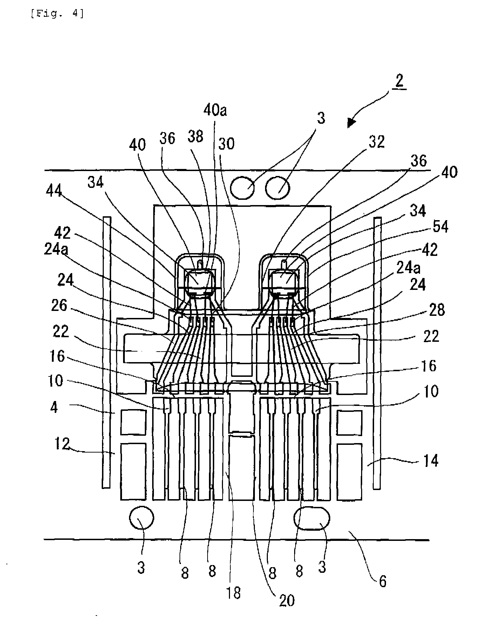

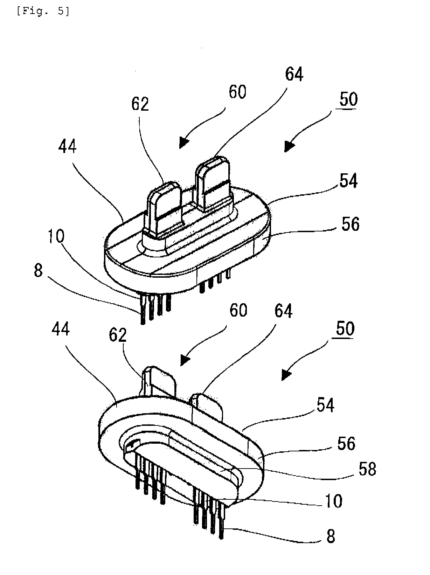

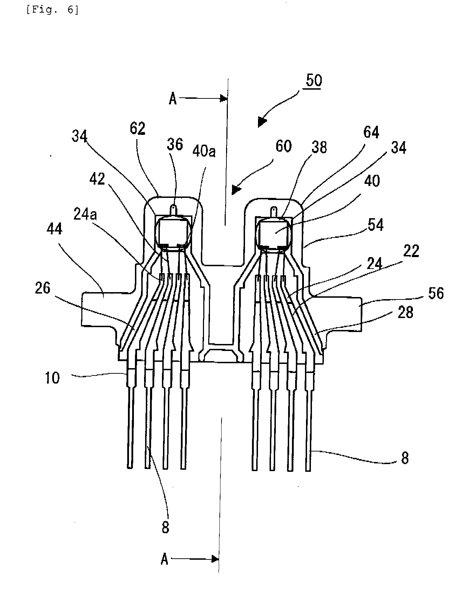

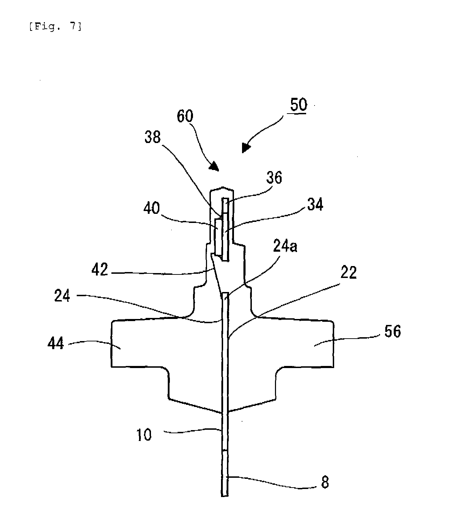

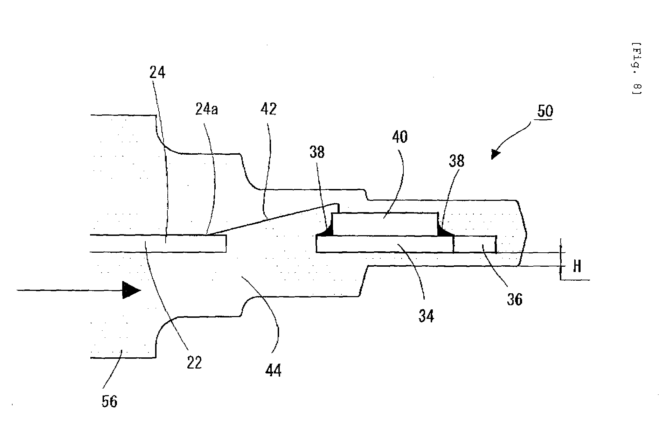

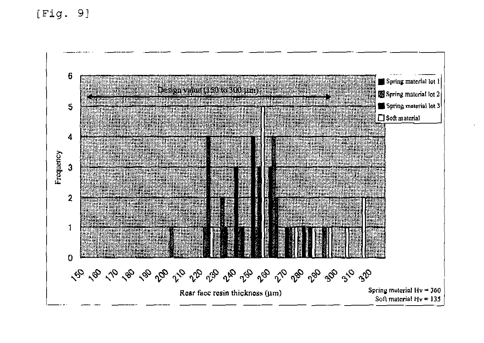

Fig. 1 is a top view showing a multi-cavity lead frame in accordance with an embodiment of the present invention. Fig. 2 is a partially enlarged top view showing the lead frame of Fig. 1. Fig. 3 is a schematic process drawing illustrating a production process of a thermal type sensor in which the lead frame of Fig. 1 is used. Fig. 4 is a partially enlarged top view showing the lead frame of Fig. 1 for illustrating a production process of a thermal type sensor in which the lead frame of Fig. 1 is used. Fig. 5 is a perspective view showing a thermal type sensor in which the lead frame of Fig. 1 is used. Fig. 6 is a vertical cross-sectional view showing the thermal type sensor of Fig. 5. Fig. 7 is a vertical cross-sectional view taken along the line A-A for the thermal type sensor of Fig. 6. Fig. 8 is a schematic view illustrating a mold process. Fig. 9 is a graph showing a result of Fig. 8.

In Figs. 1 to 3, a number 1 represents a lead frame body provided with a lead frame in accordance with the present invention in the aggregate.

A lead frame body 1 of Fig. 1 is in a so-called multi-cavity type and shows an embodiment suitable for producing a thermal type sensor.

More specifically, the lead frame body 1 is provided with a plurality of lead frames 2 that are laid out in parallel. The lead frame 2 is provided with an outer frame body 4 in a generally rectangular planar shape. The outer frame body 4 is provided with four positioning holes 3 that are formed to carry out a positioning in the case in which the outer frame body 4 is disposed in a metal mold.

Two pairs of four outer leads 8 separate at a regular interval are formed in an extending manner to right and left from a lower frame body 6 of the outer frame body 4. An external connecting terminal 10 is formed at the upper section of the outer lead 8. The external connecting terminal 10 of the outer lead 8 is supported by a horizontal supporting part 16 extending to right and left in directions of a left frame body 12 and a right frame body 14 of the outer frame body 4. A left center supporting part 18 and a right center supporting part 20 are formed in an extending manner at the center section of the lower frame body 6 and are coupled with the horizontal supporting part 16.

The inner leads 22 are formed apart at a regular interval in a sloping and extending manner toward the center at the upper section from the external connecting terminal 10. An inner lead leading end part 24 is disposed at the leading end part of the inner lead 22.

A left hanging lead 26 and a right hanging lead 28 that configure a support lead part are formed apart from the inner lead 22 at a regular interval in an extending manner corresponding to a shape of the inner lead 22 from the left frame body 12 and the right frame body 14 of the outer frame body 4, respectively. On the other hand, a left center hanging lead 30 and a right center hanging lead 32 that configure a support lead part are formed in an extending manner from the left center supporting part 18 and the right center supporting part 20, respectively.

The left hanging lead 26 and the left center hanging lead 30 are extended upward from the inner lead leading end part 24 of the inner lead 22. A die pad 34 that configures an electronic component mounting part is formed in a generally rectangular shape at the leading end part of the left hanging lead 26 and the left center hanging lead 30. The die pad 34 is disposed apart from the inner lead leading end part 24 at a regular interval and stands face to face with the inner lead leading end part 24.

Similarly, the right hanging lead 28 and the right center hanging lead 32 are extended upward from the inner lead leading end part 24 of the inner lead 22. A die pad 34 that configures an electronic component mounting part is formed in a generally rectangular shape at the leading end part of the right hanging lead 28 and the right center hanging lead 32. The die pad 34 is disposed apart from the inner lead leading end part 24 at a regular interval and stands face to face with the inner lead leading end part 24.

A supporting projection part 36 for supporting the die pad 34 in a die bond process of a step S5 and a wire bonding process of a step S6 as described later is formed in a protruding manner at the upper leading end part of the die pad 34. The supporting projection part 36 has an anchor effect in an injection molding of a mold resin and a support effect in a metal mold in a mold process of a step S7.

A method for producing a thermal type sensor by using the lead frame 2 configured as described above will be described in the following.

At first, as shown in the schematic process drawing of Fig. 3, a resist is printed in a predetermined pattern and is exposed in a resist printing and exposure process of a step S1. Subsequently, the inner lead leading end part 24 of the inner lead 22, the outer lead 8, and the external connecting terminal 10 that are shown by the sections filled with black in Fig. 2 are exposed.

In the next place, in an Ni plating (part) process of a step S2, an Ni plating that is undercoating is carried out to the inner lead leading end part 24 of the inner lead 22, the outer lead 8, and the external connecting terminal 10, which are exposed parts. In a separating process of a step S3, the resist is removed by an alkaline solution.

After that, in an Au plating (part) process of a step S4, an Au plating is carried out to the upper surface of the Ni plate that is undercoating to the inner lead leading end part 24 of the inner lead 22, the outer lead 8, and the external connecting terminal 10 to produce a frame.

In the next place, as shown in Fig. 4, a thin film chip 40 is mounted (bonded) to the die pad 34 via a jointing material 38 such as an adhesive in a die bond process of a step S5.

In a wire bonding process of a step S103 in the next place, an electrode (not shown) of the thin film chip 40 and an electrode part 24a of the inner lead leading end part 24 of the inner lead 22 are electrically connected to each other by a bonding wire 42 made of Au.

In this state, a lead frame 2 is disposed in a metal mold, and a sensor body 54 made of a mold resin 44 is formed at the predetermined part of the lead frame 2 as shown in Fig. 4 by an injection molding in which an epoxy resin is injected in a mold process of a step S7.

After that, the lead frame 2 is separated into parts of a predetermined size in a diver cut process of a step S8.

After a marking is carried out to a discriminable part such as a side part of the flange part 56 for the operation and maintenance control of a product in a marking process of a step S9, an unnecessary part of a lead frame is cut and removed from the sensor 50 and a shape of the outer lead 8 is arranged to obtain the sensor 50 that is a completed product shown in Figs. 5 to 7 in a mold separate process of a step S10.

In the above embodiment in this case, the plating is carried out to the inner lead leading end part 24 of the inner lead 22, the outer lead 8, and the external connecting terminal 10. However, a part of the partial plating can be selected as needed, and the plating can be carried out to at least a part of at least any one of the outer lead part and the inner lead part.

By the above configuration, it is not necessary to carry out the plating processing to the entire surface of a lead frame in the conventional way. Consequently, it is not necessary to carry out the conventional plating processing steps composed of two steps, the processes are simple, a cost is lower, and a large amount of waste liquid such as plating processing liquid is not generated due to a partial plating process, thereby preventing an environment from being affected.

Moreover, since a plating is carried out to the outer lead part and the inner lead part all at once, only one plating processing step is required. Consequently, it is not necessary to carry out the conventional plating processing steps composed of two stages, the processes are simple, a cost is lower, and a large amount of waste liquid such as plating processing liquid is not generated due to a partial plating process, thereby preventing an environment from being affected.

It is preferable that the plate is made of at least one kind of plating metal selected from Au, Ag, Pd, Ni, Sn, Cu, Bi, Sn-Bi, Sn-Ag, and Sn-Ag-Pb. By the above configuration, a migration does not occur at a part of the outer lead formed at a leading end part of the external connecting terminal unlike a conventional configuration, thereby preventing a bonding strength of a soldering from being lowered.

Moreover, it is preferable that the lead frame is made of a corrosion resisting metal. By the above configuration, although the lead frame is dipped in an acid solution or an alkaline solution in the plating process, the lead frame is not corroded, and a mechanical strength of the lead frame is not lowered.

Moreover, it is preferable that the lead frame is made of a hard metal (a metal having rigidity (spring property)) in which a material hardness Hv is at least 135, preferably at least 180, more preferably at least 220. Consequently, the die pad that is supported by the lead frame in a so-called cantilever state is not deformed due to a resin pressure of a mold resin in an injection molding, thereby preventing a quality as a sensor from being degraded and causing an accurate fluid discrimination to be carried out for instance.

Moreover, it is preferable that the lead frame is made of at least one kind of a metal selected from stainless steel and an Fe-Ni series alloy such as a 42 alloy. By the above configuration, although the lead frame is dipped in an acid solution or an alkaline solution in the plating process, the lead frame is not corroded, and a mechanical strength of the lead frame is not lowered. In addition, the die pad that is supported by the lead frame in a so-called cantilever state is not deformed due to a resin pressure of a mold resin in an injection molding, thereby preventing a quality as a sensor from being degraded and causing an accurate fluid discrimination to be carried out for instance.

By the above configuration, for a fluid such as a hydrocarbon liquid such as a gasoline, a naphtha, a kerosene, a light oil, and a heavy oil, and an alcohol liquid such as ethanol and methanol, and a liquid, a gas, and a particulate of a urea aqueous solution, it is possible to carry out a fluid discrimination such as the fluid type discrimination, a concentration discrimination, the existence or nonexistence discrimination, a temperature discrimination, a flow rate discrimination, and a fluid level discrimination for a fluid to be discriminated by using the physical properties of a fluid, for instance the thermal properties of a fluid. Consequently, a stability of an electronic component mounting part was confirmed by measuring a rear face resin thickness H using an X-ray transmission image. The results thereof are shown in a graph of Fig. 9.

In this case, SUS316 that is a hard metal was used as the spring material lots 1, 2, and 3, and an Fe-Ni series alloy and a stainless steel were used as a soft material.

As a result, in the case in which a hard metal (a metal having rigidity (spring property)) was used as the lead frame 2, the rear face resin thickness H was in the range of 150 to 300 $\mu$m of a design value. On the other hand, in the case in which a soft material was used, the rear face resin thickness H was at least 300 $\mu$m, which indicates a dished direction. This is because the die pad 34 that is an electronic component mounting part is molded in an upward pressed state by a flow of a resin in molding. As described above, a stability of an electronic component mounting part can be confirmed by using a hard metal (a metal having rigidity (spring property)) as the lead frame.

As shown in Figs. 5 to 7, a sensor 50 configured as described above is provided with a sensor body 54 made of a mold resin 44, and the sensor body 54 is provided with a flange part 56 in a generally elliptical shape, a rear face protrusion part 58 that is protruded on a rear face of the flange part 56, and a detecting part 60 that is protruded on a surface of the flange part 56.

The detecting part 60 is composed of a pair of a fluid discrimination detecting part 62 and a fluid temperature detecting part 64 in a rectangular flat plate shape that are disposed apart at a regular interval. The fluid discrimination detecting part 62 and the fluid temperature detecting part 64 have the same structure basically, and are provided with an electrical heating element and a temperature sensing element. For the fluid temperature detecting part 64, an electrical heating element is not operated but only a temperature sensing element is operated.

As shown in Figs. 5 and 7, the fluid discrimination detecting part 62 and the fluid temperature detecting part 64 are provided with a metal die pad 34 that functions as a heat transfer member that is disposed in the sensor body 54 that is sealed with a mold resin 44. A thin film chip 40 is mounted to a mounting plane of the die pad 34 via a jointing material 38.

In the sensor body 54, a plurality of inner leads 22 are disposed in such a manner that the inner leads 22 and the metal die pad 34 thereof are disposed face to face, that the inner leads 22 are disposed apart from the metal die pad 34 at a regular interval, and that the inner leads 22 are separate from each other at a regular interval. An external connecting terminal 10 is disposed in an extending manner in a direction of the rear face protrusion part 58, and an outer lead 8 is formed at a leading end part of the external connecting terminal 10.

An electrode of the thin film chip 40 and an electrode 24a of the inner lead leading end part 24 are electrically connected to each other by a bonding wire 42 made of Au.

For the sensor 50, the detecting part 60 that is composed of the fluid discrimination detecting part 62 and the fluid temperature detecting part 64 and that is a part that comes into contact with a fluid to be discriminated is sealed with the mold resin 44. In addition, the lead frame 2 that includes the inner lead 22, the die pad 34, and the hanging leads 26, 28, 30, and 32 is configured so that the lead frame 2 is not exposed to a fluid to be discriminated.

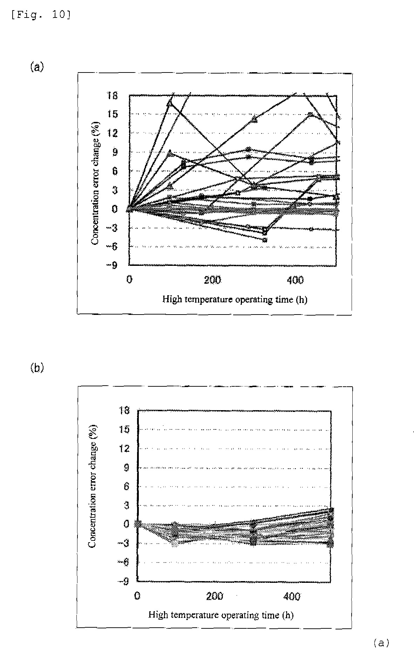

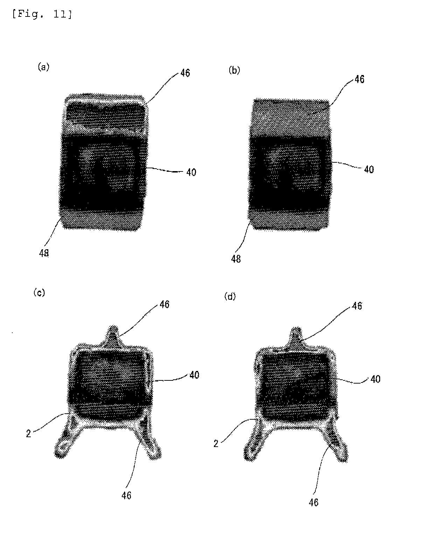

Fig. 10 is a graph showing a comparison of an operating time and a change of a concentration error in the case in which a conventional sensor in which a lead frame is exposed to a fluid to be discriminated and a thermal type sensor in which the lead frame in accordance with the present invention is used are used as a concentration sensor of liquid. Fig. 11 is an ultrasonic transmission image view for using the ultrasonic test equipment (C-Mode Scanning Acoustic Microscope D-9000: manufactured by Sonoscan Inc.) for illustrating a change of a state inside the sensor related to the time course in a state in which a sensor having a configuration in which a conventional lead frame is exposed to a fluid to be discriminated and a sensor in accordance with the present invention are in water. In a practical sense, an ultrasonic transmission image view in which the ultrasonic test equipment is used shows a mold resin 44 as a black section. However, in Fig. 11, a section of the mold resin 44 is processed as a white section in order to help an understanding of the drawing.

As shown in Fig. 10(a), in the case of a conventional sensor in which a lead frame is exposed to a fluid to be discriminated, an error of maximum 18% or larger in a concentration to be measured according to an operating time. This is because a fluid to be discriminated enters the sensor body 54 between the lead frame 48 that is exposed to a fluid to be discriminated and the mold resin 44, whereby the thin film chip 40 is influenced. On the other hand, as shown in Fig. 10(b), for the sensor in accordance with the present invention, even in the case in which the sensor is operated for a long time, an error of a concentration to be measured is approximately maximum 3%.

Moreover, as shown in Figs. 11(a) and 11(b), for the conventional sensor in which the lead frame 48 is used, a change in a state with the passage of time is found for a separate part 46 of the lead frame 48 and the mold resin 44. This is because water enters the separate part 46 between the lead frame 48 and the mold resin 44 that have been dipped in water, and the separate part 46 is filled with water.

On the other hand, as shown in Figs. 11(c) and 11(d), for the sensor in which the lead frame 2 in accordance with the present invention is used, a change in a state with the passage of time is not found for a separate part 46 of the lead frame 2 and the mold resin 44.

As described above, even in the case in which the sensor is operated for a long time, a fluid to be discriminated does not enter between the lead frame 2 and the mold resin 44 unlike the conventional sensor by a configuration in which the lead frame 2 is not exposed to a fluid to be discriminated, thereby suppressing a deterioration of an accuracy as a sensor.

For the thermal type sensor 50 configured as described above, a fluid discrimination is carried out based on a method that is disclosed in Patent document 3 (Japanese Patent Application Laid-Open Publication No. 2005-337969).

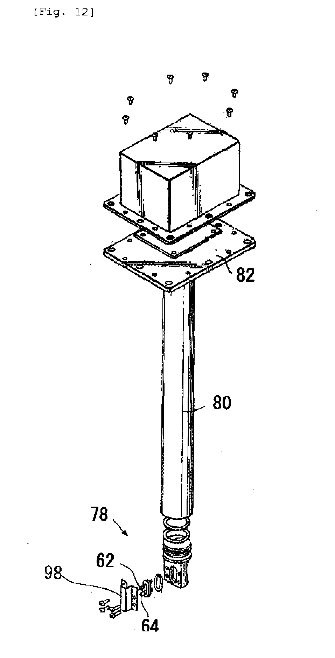

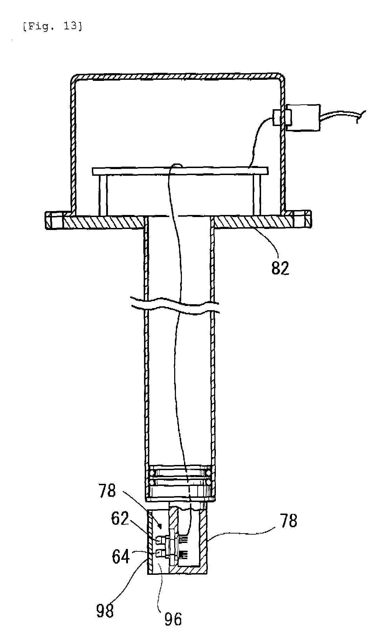

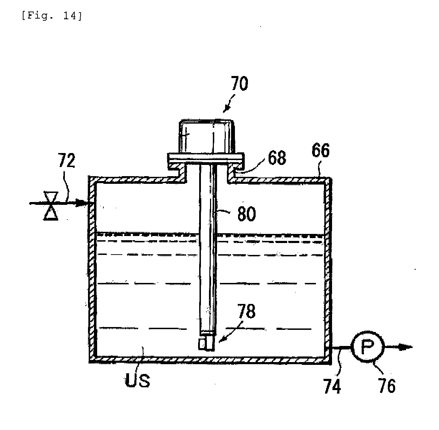

More specifically, Fig. 12 is an exploded perspective view showing an embodiment in which a sensor 50 in accordance with the present invention is applied to a fluid discrimination apparatus. Fig. 13 is a partial cross-sectional view of Fig. 10. Fig. 14 is a view showing a mounting state of a fluid discrimination apparatus in accordance with the present invention to a tank.

As shown in Figs. 12 to 14, an opening part 68 is formed at the upper section of the tank 66, and a fluid discrimination apparatus 70 in accordance with the present invention is attached to the opening part.

The tank 66 is provided with an inlet pipe 72 to which a fluid is injected and an outlet pipe 74 from which a fluid is taken away. The outlet pipe 74 is connected to the tank at the height position close to the bottom part of the tank 66, and is also connected to a fluid usage apparatus (not shown) via a pump 76.

The fluid discrimination apparatus is provided with a fluid discrimination sensor part 78 and a supporting part 80. The fluid discrimination sensor part 78 is attached to one end part (a lower end part) of the supporting part 80, and an attachment part 82 for being attached to the tank opening part 68 is formed at the other end part (an upper end part) of the supporting part 80.

The fluid discrimination sensor part 78 includes a fluid discrimination detecting part 62 provided with an electrical heating element and a temperature sensing element and a fluid temperature detecting part 64 for measuring a temperature of a fluid.

The fluid discrimination apparatus 70 configured as described above makes an electrical heating element to produce heat by a power distribution, and heats a temperature sensing element by the heat generation. The fluid discrimination apparatus 70 then gives a thermal influence by a fluid to be discriminated to a heat transfer from the electrical heating element to the temperature sensing element, and carries out a fluid discrimination as described above for a fluid to be discriminated based on an electrical output corresponded to an electrical resistance of the temperature sensing element based on a method that is disclosed in Patent document 3 (Japanese Patent Application Laid-Open Publication No. 2005-337969).

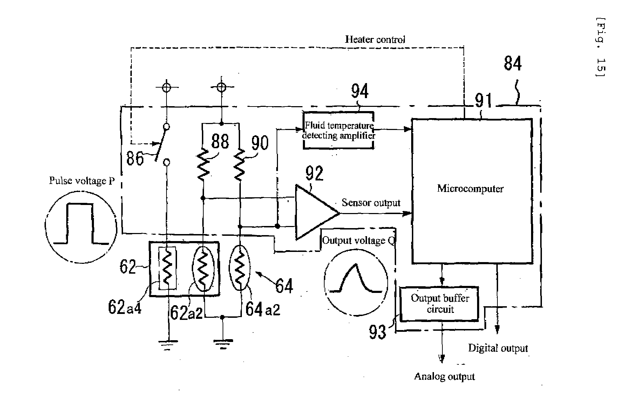

A discrimination process of a kind of liquid will be described in the following as an embodiment of a fluid discrimination. In the present embodiment, a part that is surrounded by an alternate long and short dash line in Fig. 15 is formed in a custom IC 84.

Fig. 15 shows a configuration in which the switch 86 is simply opened and closed as a matter of practical convenience. However, a plurality of voltage application paths that can apply voltages different from each other can also be formed in a fabrication of the custom IC 84, and any of the voltage application paths can be selected in the case in which a heater is controlled. By the above configuration, a range of selecting a characteristic of the electrical heating element 62a4 of the fluid discrimination detecting part 62 can be extremely enlarged. In other words, a voltage that is optimum for a measurement can be applied corresponding to the characteristics of the electrical heating element 62a4. Moreover, a plurality of voltage applications different from each other can be carried out in the case in which a heater is controlled, whereby a range of types of a fluid to be discriminated can be enlarged.

Fig. 15 shows the resistors 88 and 90 having a fixed resistance value as a matter of practical convenience. However, variable resistors can be formed as the resistors 88 and 90 in the case in which the custom IC 84 is formed, and the resistance values of the resistors 88 and 90 can be changed as needed in a measurement. Similarly, the differential amplifier 70 and the fluid temperature detecting amplifier 71 can be formed in such a manner that the characteristics of the differential amplifier 92 and the fluid temperature detecting amplifier 94 can be adjusted in the case in which the custom IC 84 is formed, and the characteristics of the amplifiers can be changed as needed in a measurement.

By the above configuration, the characteristics of the fluid kind detecting circuit can be easily set to be optimum, and a dispersion of the measurement characteristics, which occurs based on an individual dispersion on a production of the fluid discrimination detecting part 62 and the fluid temperature detecting part 64 and an individual dispersion on a production of the custom IC 84, can be reduced, thereby improving a production yield.

A fluid kind discrimination operation in accordance with the embodiment of the present invention will be described in the following.

In the case in which a fluid US to be measured is stored into the tank 66, a urea aqueous solution is also filled with in the measured fluid introduction path 96 that is formed by the cover member 98 that covers the fluid discrimination sensor part 78. The fluid US to be measured that has been stored into the tank 66 and the measured fluid introduction path 96 does not flow in substance.

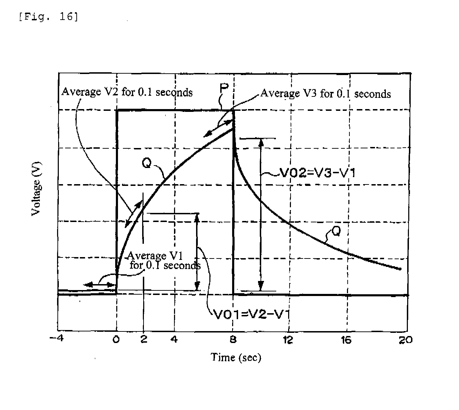

The switch 86 is closed for a predetermined time (8 seconds for instance) by a heater control signal that is output from the microcomputer 91 to the switch 86, and a single pulse voltage P of a predetermined height (10 V for instance) is applied to the electrical heating element 62a4 to make the electrical heating element generate a heat. As shown in Fig. 16, an output voltage (a sensor output) of the differential amplifier 92 at this time is increased by a gradual process in a voltage application to the electrical heating element 62a4, and is decreased by a gradual process after a voltage application to the electrical heating element 62a4 is completed.

As shown in Fig. 16, for the predetermined time (0.1 seconds for instance) before a voltage application to the electrical heating element 62a4 is started, the microcomputer 91 carries out a sampling of a sensor output predetermined times (256 times for instance) and carries out an operation for getting the average value to obtain an average initial voltage value V1. The average initial voltage value V1 is corresponded to an initial temperature of the temperature sensing element 62a2.

As shown in Fig. 16, when a comparatively short first time (for instance, 1/2 or less of an application time of a single pulse, 0.5 to 3 seconds; 2 seconds in Fig. 16) elapses after a voltage application to the electrical heating element 62a4 is started (more specifically, immediately before the first time elapses), the microcomputer 91 carries out a sampling of a sensor output predetermined times (256 times for instance) and carries out an operation for getting the average value to obtain an average first voltage value V2. The average first voltage value V2 is corresponded to a first temperature when the first time elapses after an application of a single pulse to the electrical heating element 62a4 is started. A difference V01 of the average initial voltage value V1 and the average first voltage value V2 (= V2-V1) is obtained as a fluid kind corresponded first voltage value.

As shown in Fig. 16, when a comparatively long second time (for instance, an application time of a single pulse; 8 seconds in Fig. 16) elapses after a voltage application to the electrical heating element 62a4 is started (more specifically, immediately before the second time elapses), the microcomputer 91 carries out a sampling of a sensor output predetermined times (256 times for instance) and carries out an operation for getting the average value to obtain an average second voltage value V3. The average second voltage value V3 is corresponded to a second temperature when the second time elapses after an application of a single pulse to the electrical heating element 62a4 is started. A difference V02 of the average initial voltage value V1 and the average second voltage value V3 (= V3-V1) is obtained as a fluid kind corresponded second voltage value.

For the meanwhile, a part of a heat that has been generated by the electrical heating element 62a4 based on a voltage application of a single pulse as described above is transferred to the temperature sensing element 62a2 via a fluid to be measured. This heat transfer is mainly classified into two different modes depending on time from a pulse application start. More specifically, for a first stage within a comparatively short time (for instance, 3 seconds, in particular 2 seconds) from a pulse application start, the conduction is dominant mainly as a heat transfer (consequently, the fluid kind corresponded first voltage value V01 is mainly influenced by a coefficient of thermal conductivity of a fluid).

On the other hand, for a second stage after the first stage, a natural convection is dominant mainly as a heat transfer (consequently, the fluid kind corresponded second voltage value V02 is mainly influenced by a coefficient of kinematic viscosity of a fluid). This is because a natural convection of a measured fluid that has been heated in the first stage occurs in the second stage, whereby a ratio of a heat transfer becomes higher.

As described above, it is said that 32.5% is optimum as a concentration (a weight percent: similarly in the following) of a urea aqueous solution that is used for an emission gas purification system. Consequently, it can be defined that an acceptable range of a urea concentration of a urea aqueous solution that should be contained in a urea aqueous solution tank 66 is 32.5% ± 5% for instance. The region ±5% of the acceptable range can be modified as needed at a request. In other words, for the present embodiment, it is defined that the predetermined fluid is a urea aqueous solution having a urea concentration in the range of 32.5% ± 5%.

The fluid kind corresponded first voltage value V01 and the fluid kind corresponded second voltage value V02 are changed as a urea concentration of a urea aqueous solution varies. Consequently, there are a range (a predetermined range) of the fluid kind corresponded first voltage value V01 and a range (a predetermined range) of the fluid kind corresponded second voltage value V02 corresponding to a urea aqueous solution having a urea concentration in the range of 32.5% ± 5%.

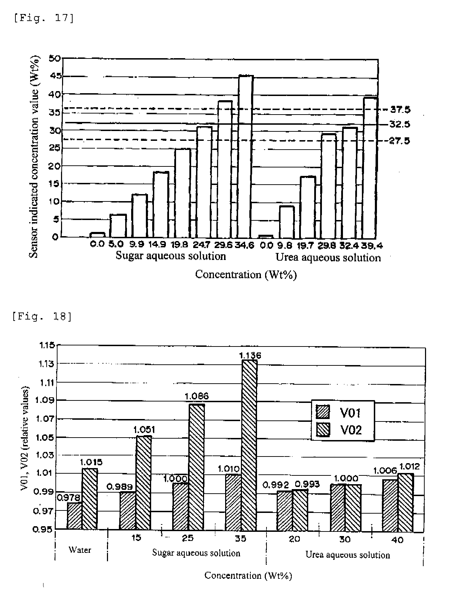

For the meanwhile, even for a fluid other than a urea aqueous solution, an output in the predetermined range of the fluid kind corresponded first voltage value V01 and an output in the predetermined range of the fluid kind corresponded second voltage value V02 can be obtained in some cases. In other words, even in the case in which the fluid kind corresponded first voltage value V01 or the fluid kind corresponded second voltage value V02 is in the predetermined range, the fluid is not always the predetermined urea aqueous solution. For instance, as shown in Fig. 17, there is a fluid kind corresponded first voltage value of a sugar aqueous solution having a sugar concentration in the range of 25% ± 3% in a range of the fluid kind corresponded first voltage value V01 that is obtained by a urea aqueous solution having a urea concentration in the predetermined range of 32.5% ± 5% (that is, in the range of 32.5% ± 5% in the case in which it is converted into a sensor indicated concentration value).

However, a value of the fluid kind corresponded second voltage value V02 that is obtained by a sugar aqueous solution in the range of the sugar concentration is completely out of the range of the fluid kind corresponded second voltage value V02 that is obtained by a urea aqueous solution having a urea concentration in the predetermined range. In other words, as shown in Fig. 18, the fluid kind corresponded first voltage value V01 of a sugar aqueous solution having a sugar concentration in the range of 15% to 35% including a sugar concentration in the range of 25% ± 3% partially overlaps that of a urea aqueous solution having a urea concentration in the predetermined range. However, the fluid kind corresponded second voltage value V02 of the sugar aqueous solution is greatly different from that of the urea aqueous solution having a urea concentration in the predetermined range.

Fig. 18 shows the both of the fluid kind corresponded first voltage value V01 and the fluid kind corresponded second voltage value V02 as a relative value in the case in which the fluid kind corresponded first voltage value V01 and the fluid kind corresponded second voltage value V02 of a urea aqueous solution having a urea concentration of 30% are 1.000. As described above, in the case in which that the fluid kind corresponded first voltage value V01 and the fluid kind corresponded second voltage value V02 are in the predetermined ranges is acceptance criteria of whether a solution is the predetermined fluid or not, it can be discriminated with a certainty that the above sugar aqueous solution is not a predetermined fluid.

The fluid kind corresponded second voltage value V02 may overlap that of the predetermined fluid in some cases. In this case however, the fluid kind corresponded first voltage value V01 is different from that of the predetermined fluid. Consequently, it can be discriminated with a certainty by the above acceptance criteria that the fluid is not the predetermined fluid.

The present invention is for carrying out a discrimination of a kind of a fluid by utilizing that a relationship between the fluid kind corresponded first voltage value V01 and the fluid kind corresponded second voltage value V02 are different depending on a kind of a solution as described above. More specifically, the fluid kind corresponded first voltage value V01 and the fluid kind corresponded second voltage value V02 are influenced by physical properties different from each other for fluids, that is a coefficient of thermal conductivity and a coefficient of kinematic viscosity, and the relationships are different from each other depending on a kind of a solution, thereby enabling the above a discrimination of a kind of a fluid. By reducing the predetermined range of a urea concentration, an accuracy of a discrimination can be further improved.

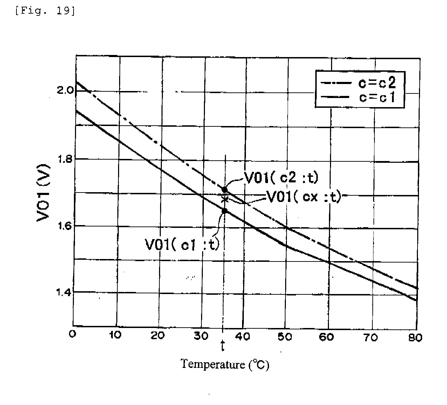

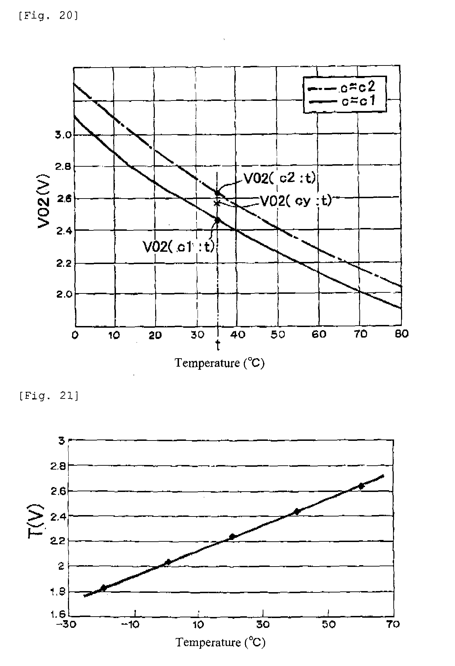

In an embodiment in accordance with the present invention, a first calibration curve that indicates a relationship between a temperature and the fluid kind corresponded first voltage value V01 and a second calibration curve that indicates a relationship between a temperature and the fluid kind corresponded second voltage value V02 are obtained in advance for some urea solutions having a known urea concentration (reference urea solutions), and the calibration curves are stored into a storage means of a microcomputer 91. Figs. 19 and 20 show the examples of a first calibration curve and a second calibration curve, respectively. In the examples, a calibration curve is prepared for reference urea solutions having urea concentrations c1 (for instance 27.5%) and c2 (for instance 37.5%).

As shown in Figs. 19 and 20, the fluid kind corresponded first voltage value V01 and the fluid kind corresponded second voltage value V02 depend on a temperature. Consequently, in the case in which a fluid to be measured is discriminated by using the calibration curves, a fluid temperature corresponded output value T that is input via the fluid temperature detecting amplifier 94 from the temperature sensing element 64a2 of the fluid temperature detecting part 64 is also used. An example of a fluid temperature corresponded output value T is shown in Fig. 21. Such a calibration curve is also stored into a storage means of a microcomputer 91.

In the case in which the fluid kind corresponded first voltage value V01 is measured, a temperature value is obtained by using the calibration curve of Fig. 21 from a fluid temperature corresponded output value T that has been obtained for a fluid to be measured at first. By using the obtained temperature value as t, for the first calibration curve of Fig. 19, the fluid kind corresponded first voltage values V01 (c1;t) and V01 (c2;t) of each calibration curve corresponding to the temperature value t are then obtained.

The cx of the fluid kind corresponded first voltage value V01 (cx;t) that has been obtained for a fluid to be measured is determined by carrying out a proportion operation using the fluid kind corresponded first voltage values V01 (c1;t) and V01 (c2;t) of each calibration curve. More specifically, cx is obtained from the following expression (1) based on V01 (cx;t), V01 (c1;t), and V01 (c2;t):

$$cx = c1 + (c2-c1)[V01(cx;t)-V01(c1;t)]/[V01(c2;t)-V01(c1;t)] \quad \ldots$$

$$(1)$$

Similarly, in the case in which the fluid kind corresponded second voltage value V02 is measured, for the second calibration curve of Fig. 20, the fluid kind corresponded second voltage values V02 (c1;t) and V02 (c2;t) of each calibration curve corresponding to the temperature value t that has been obtained for a fluid to be measured as described above are obtained. The cy of the fluid kind corresponded second voltage value V02 (cy;t) that has been obtained for a fluid to be measured is determined by carrying out a proportion operation using the fluid kind corresponded second voltage values V02 (c1;t) and V02 (c2;t) of each calibration curve.

More specifically, cy is obtained from the following expression (2) based on V01 (cy;t), V01 (c1;t), and V01 (c2;t):

$$Cy = c1 + (c2-c1)[V02(cy;t)-V02(c1;t)]/[V02(c2;t)-V02(c1;t)] \quad \ldots$$

$$(2)$$

Moreover, by adopting the first and second calibration curves of Figs. 19 and 20 in which the fluid temperature corresponded output value T is used as substitute for a temperature, a storage of the calibration curve of Fig. 21 and a conversion using the calibration curve can be omitted.

As described above, a predetermined range that varies depending on a temperature can be defined for each of the fluid kind corresponded first voltage value V01 and the fluid kind corresponded second voltage value V02. In the case in which c1 is defined as 27.5% and c2 is defined as 37.5% as described above, a region that is surrounded by two calibration curves of each of Figs. 19 and 20 is corresponded to a predetermined fluid (that is, a urea aqueous solution having a urea concentration in the range of 32.5% ± 5%).

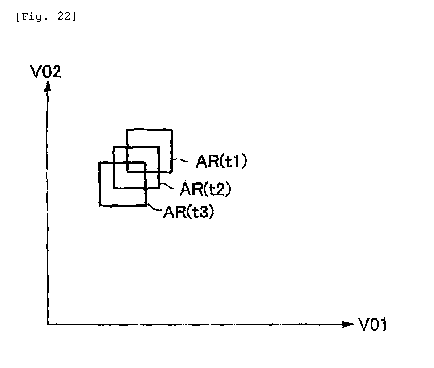

Fig. 22 is a graph schematically illustrating that acceptance criteria for discriminating a predetermined fluid in accordance with a combination of the fluid kind corresponded first voltage value V01 and the fluid kind corresponded second voltage value V02 vary depending on a temperature. As a temperature is increased as t1, t2, and t3, regions AR (t1), AR (t2), and AR (t3) that are decided as predetermined fluids are moved.

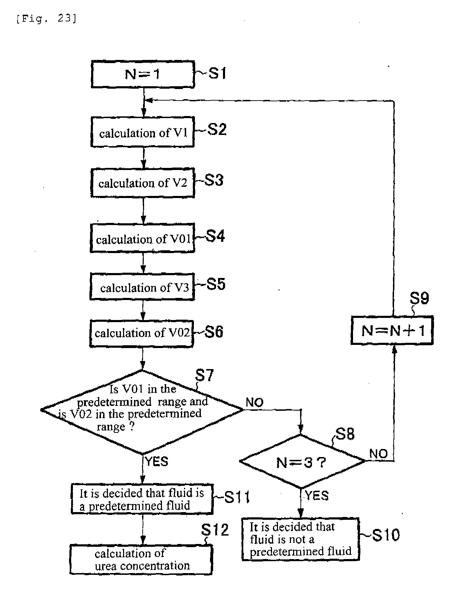

Fig. 23 is a flow chart showing a discrimination process of a kind of a fluid at the microcomputer 91.

At first, N=1 is stored into a microcomputer before a pulse voltage is applied to the electrical heating element 62a4 by a heater control (S1), and a sensor output is sampled to obtain an average initial voltage value V1 (S2). In the next place, a heater control is carried out, and a sensor output is sampled when a first time elapses from a start of a voltage application to the electrical heating element 62a4 to obtain an average first voltage value V2 (S3) . In the next place, an operation of V2-V1 is carried out to obtain the fluid kind corresponded first voltage value V01 (S4). In the next place, a sensor output is sampled when a second time elapses from a start of a voltage application to the electrical heating element 62a4 to obtain an average second voltage value V3 (S5). In the next place, an operation of V3-V1 is carried out to obtain the fluid kind corresponded second voltage value V02 (S6).

In the next place, a temperature value t that has been obtained for a fluid to be measured is referred to, and it is judged whether the condition that the fluid kind corresponded first voltage value V01 is in the predetermined range at the temperature and the fluid kind corresponded second voltage value V02 is in the predetermined range at the temperature is satisfied or not (S7). In the case in which it is judged that at least one of the fluid kind corresponded first voltage value V01 and the fluid kind corresponded second voltage value V02 is not in the predetermined range thereof in S7 (NO), it is judged whether the above stored value N is 3 or not (SB) In the case in which it is judged that N is not 3 in S8 (that is, the current measured routine is not third (more specifically, the current measured routine is first or second)) (NO), the stored value N is subsequently increased by 1 (S9), and a step is returned to S2.

On the other hand, in the case in which it is judged that N is 3 in S8 (that is, the current measured routine is third) (YES), it is decided that a fluid to be measured is not a predetermined fluid (S10).

On the other hand, in the case in which it is judged that both of the fluid kind corresponded first voltage value V01 and the fluid kind corresponded second voltage value V02 is in the predetermined range thereof in S7 (YES), it is decided that a fluid to be measured is a predetermined fluid (S11).

In the present invention, a urea concentration of a urea aqueous solution is calculated after S11 (S12). The calculation of a concentration can be carried out by using the above expression (1) based on an output of the fluid temperature detecting part 64, that is, the temperature value t that has been obtained for a fluid to be measured, the fluid kind corresponded first voltage value V01, and the first calibration curve of Fig. 19. Or otherwise, the calculation of a concentration can be carried out by using the above expression (2) based on an output of the fluid temperature detecting part 64, that is, the temperature value t that has been obtained for a fluid to be measured, the fluid kind corresponded second voltage value V02, and the second calibration curve of Fig. 20.

By the above configuration, a discrimination of a kind of a fluid can be carried out with accuracy and with rapidity. The routine of a discrimination of a kind of a fluid can be carried out as needed when an engine of an automobile is started, on a periodic basis, when there is a request from a driver or an automobile (an ECU that will be described later) side, or when a key of an automobile is turned off. By the routine, it can be monitored whether a fluid in a urea tank is a urea aqueous solution having a predetermined urea concentration or not by a desired manner.

A signal that indicates a kind of a fluid and that has been obtained as described above (a signal that indicates whether or not a fluid is a predetermined fluid and a urea concentration in the case in which a fluid is a predetermined fluid (a fluid is a urea aqueous solution having a predetermined urea concentration)) is output to an output buffer circuit 93 shown in Fig. 15 via a D/A converter (not shown). The signal is then output to a main computer (ECU) that carries out a combustion control of an engine of an automobile (not shown) as an analog output via a terminal pin, a power circuit board, and a waterproof wire. An analog output voltage value corresponded to a temperature of a fluid is also output to a main computer (ECU) in a similar route. On the other hand, the signal that indicates a kind of a fluid can be taken out as a digital output as needed, and can be input to an apparatus that carries out an indication, an alarm or the like in a similar route.

Moreover, an alert can be issued in the case in which it is detected that a temperature of a urea aqueous solution is lowered to a temperature close to that at which a urea aqueous solution is frozen (approximately -13°C) based on the fluid temperature corresponded output value T that is input from the fluid temperature detecting part 64.

For the above discrimination of a kind of a fluid, a natural convection is utilized, and a principle of that a coefficient of kinematic viscosity of a fluid to be measured such as a urea aqueous solution and a sensor output have a correlative relationship is utilized. To improve an accuracy of the discrimination of a kind of a fluid, it is preferable that a forced flow based on an external factor is hard to occur as much as possible to a fluid to be measured around a container body 20A in which a heat transfer is carried out between the fluid discrimination detecting part 62, the fluid temperature detecting part 64 and a fluid to be measured. From a point of view, a cover member 98, in particular a member that forms the measured fluid introduction path in a vertical direction can be used preferably. Moreover, the cover member 98 can be functioned as a protection member for preventing a contact of a foreign matter.

In the above embodiment, a urea aqueous solution having a predetermined urea concentration is used as predetermined fluid. However, in the present invention, a predetermined fluid can also be an aqueous solution or other fluid in which a material other than urea is used as a solute.

In the above embodiment, a fluid to be measured was used as a fluid to be discriminated. For instance as described later, for a fluid such as a hydrocarbon liquid such as a gasoline, a naphtha, a kerosene, a light oil, and a heavy oil, and an alcohol liquid such as ethanol and methanol, and a liquid, a gas, and a particulate of a urea aqueous solution, it is possible to carry out a fluid discrimination such as the fluid type discrimination, a concentration discrimination, the existence or nonexistence discrimination, a temperature discrimination, a flow rate discrimination, a fluid leakage discrimination, a fluid level discrimination, and an ammonia generation amount for a fluid to be discriminated by using the physical properties of a fluid, for instance the thermal properties of a fluid.

(Embodiment 1) Corrosion resistance test of a lead frame material

The SUS316 as stainless steel and a 42 alloy as an Fe-Ni series alloy were used as a lead frame material in accordance with the present invention, and a test piece (10 mm × 100 mm) was fabricated. By way of comparison, a test piece (10 mm × 100 mm) was fabricated using Cu as a conventional lead frame material. A corrosion resistance test was then carried out. As a test condition, the lead frame material was dipped into a urea aqueous solution of 32.5% at 60°C, and an appearance of the lead frame material and a change of a color of the urea aqueous solution were observed.

For a lead frame material in accordance with the present invention in which SUS316 and a 42 alloy were used, an appearance of the lead frame material was not changed and a change of a color of the urea aqueous solution was not found even at 112th day.

On the other hand, for a lead frame material in which Cu was used as a conventional lead frame material, a change of an appearance of the lead frame material and a change of a color of the urea aqueous solution were found at the second day, and Cu of the lead frame material was extinguished by a corrosion at 104th day.

As a result, it is found that the case in which SUS316 and a 42 alloy that are a lead frame material in accordance with the present were used is dramatically excellent in corrosion resistant characteristics as compared with the case in which Cu was used as a conventional lead frame material.

(Embodiment 2) Influence to a corrosion resistance test and a concentration measurement

The three lead frames made of a copper sensor mold (No. 3 to 8) and three lead frames made of SUS (SUS304) (No. 6 to 8) were disposed in series in a tubular case made of transparent acrylic. While the case was held at 45°C, a fluid circulation of a urea aqueous solution of 32.5% at 60°C was carried out by a fluid transmission pump at 50 rpm, and a transition of an output value (a concentration measurement) was measured before and after corrosion was found.

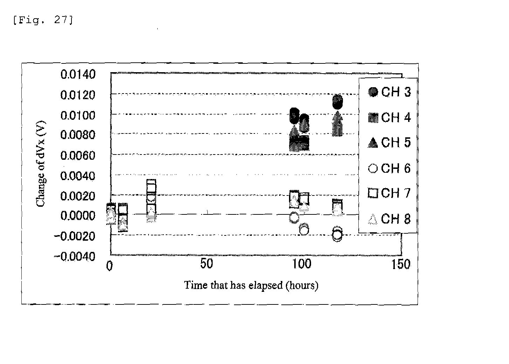

As a result, Fig. 27 shows a transition of a difference from an initial value (an average value) of dVx of No. 3 to 8.

As clarified by Fig. 27, a dVx value of copper fins of No. 3 to 5 clearly varies in the range of 8 to 10 mV, and an appearance of the leading end part was changed from a light red at an initial color to a dark red. On the other hand, a dVx value of SUS fins of No. 6 to 8 did not vary and the SUS fins were not corroded from the standpoint of appearance. As a result, it is said that a dVx value of copper fins of No. 3 to 5 was increased since deterioration (corrosion) of copper fins did occur.

Consequently from the above results, it is found that the case in which SUS304 that is a lead frame material in accordance with the present was used is excellent in corrosion resistant characteristics as compared with the case in which Cu was used as a conventional lead frame material. In addition, it is found that a measurement is not influenced and an accurate fluid discrimination can be carried out for the case in which SUS304 that is a lead frame material in accordance with the present was used.

While the preferred embodiments in accordance with the present invention have been described above, the present invention is not restricted to the embodiments. In the above embodiments, the sensor body 54 made of the mold resin 44 was formed as shown in Fig. 4. However, a sensor can be covered by a ceramic or a metal and can be airtightly sealed inside by inert gas for instance.

Moreover, examples suitable for producing a thermal type sensor were shown in the above embodiments. However, in addition to a sensor for carrying out a fluid discrimination, many kinds of sensors and an electronic device such as a semiconductor device can also be used.

Furthermore, examples suitable for producing a thermal type sensor were shown in the above embodiments. However, in addition to a sensor for carrying out a fluid discrimination, many kinds of sensors and an electronic device such as a semiconductor device can also be used, and various changes, modifications, and functional additions can be thus made without departing from the scope of the present invention.

**Claims**

1.   A lead frame comprising an outer lead part and an inner lead part,
     wherein a plating is carried out to at least a part of at least any one of the outer lead part and the inner lead part.

2.   The lead frame as defined in claim 1, wherein a plating is carried out to the outer lead part and the inner lead part as the whole of the lead frame, or a plating is carried out to the outer lead part after a plating is carried out to the inner lead part.

3. The lead frame as defined in claim 1 or 2, wherein the plate is made of at least one kind of a plating metal selected from Au, Ag, Pd, Ni, Sn, Cu, Bi, Sn-Bi, Sn-Ag, and Sn-Ag-Pb.

4. The lead frame as defined in any one of claims 1 to 3, wherein the lead frame is made of a corrosion resisting metal.

5. The lead frame as defined in any one of claims 1 to 4, wherein the lead frame is made of a hard metal having a material hardness Hv is at least 135.

6. The lead frame as defined in any one of claims 1 to 5, wherein the lead frame is made of at least one kind of a metal selected from stainless steel and an Fe-Ni series alloy.

7. The lead frame as defined in any one of claims 1 to 6, wherein the lead frame is provided with an electronic component mounting part that is used for mounting an electronic component.

8. The lead frame as defined in claim 7, wherein the inner lead part and an electronic component mounted to the electronic component mounting part are electrically connected to each other.

9. The lead frame as defined in claim 7 or 8, wherein the inner lead part and an electronic component mounted to the electronic component mounting part are air-tightly sealed or sealed by a resin.

10. A lead frame comprising an outer lead part, an inner lead part, and an electronic component mounting part that is used for mounting an electronic component,
wherein a support lead part for supporting the electronic component mounting part is formed from the outer lead part side.

11. The lead frame as defined in claim 10, comprising at least two support lead parts.

12. The lead frame as defined in claim 10 or 11, wherein the inner lead part and an electronic component mounted to the electronic component mounting part are electrically connected to each other.

13. The lead frame as defined in any one of claims 10 to 12, wherein the inner lead part, an electronic component mounted to the electronic component mounting part, and the support lead part are air-tightly sealed or sealed by a resin.

14. The lead frame as defined in claim 13, wherein a lead frame part that is air-tightly sealed or sealed by a resin is not exposed for an exposure part that is exposed to an external environment in use in a part that is air-tightly sealed or sealed by a resin.

15. An electronic device comprising the lead frame as defined in any one of claims 1 to 14.

16. The electronic device as defined in claim 15, wherein the electronic device is a sensor that is used for carrying out a fluid discrimination.

17. The electronic device as defined in claim 16, wherein the exposure part is exposed to a fluid in the fluid discrimination.

18. The electronic device as defined in claim 17, wherein the fluid discrimination is at least one discrimination of the fluid type discrimination, a concentration discrimination, the fluid existence or nonexistence discrimination, a fluid temperature discrimination, a flow rate discrimination, a fluid leakage discrimination, and a fluid level discrimination.

19. A method of producing a lead frame comprising an outer lead part and an inner lead part,
wherein a plating is carried out to at least a part of at least any one of the outer lead part and the inner lead part.

20. The method of producing a lead frame as defined in claim 19, wherein a plating is carried out to the outer lead part and the inner lead part as the whole of the lead frame, or a plating is carried out to the outer lead part after a plating is carried out to the inner lead part.

21. The method of producing a lead frame as defined in claim 19 or 20, wherein the plate is made of at least one kind of a plating metal selected from Au, Ag, Pd, Ni, Sn, Cu, Bi, Sn-Bi, Sn-Ag, and Sn-Ag-Pb.

22. The method of producing a lead frame as defined in any one of claims 19 to 21, wherein the lead frame is made of a corrosion resisting metal.

23. The method of producing a lead frame as defined in any one of claims 19 to 22, wherein the lead frame is made of a hard metal having a material hardness Hv is at least 135.

24. The method of producing a lead frame as defined in any one of claims 19 to 23, wherein the lead frame is made of at least one kind of a metal selected from stainless steel and an Fe-Ni series alloy.

25. The method of producing a lead frame as defined in any one of claims 19 to 24, wherein the lead frame is provided with an electronic component mounting part that is used for mounting an electronic component.

26. The method of producing a lead frame as defined in claim 25, wherein the inner lead part and an electronic component mounted to the electronic component mounting part are electrically connected to each other.

27. The method of producing a lead frame as defined in claim 25 or 26, wherein the inner lead part and an electronic component mounted to the electronic component mounting part are air-tightly sealed or sealed by a resin.

28. The method of producing a lead frame as defined in claim 27, wherein a plating is carried out to an electronic component mounted to the electronic component mounting part before the electronic component is sealed by a resin mold.

29. A method of producing a lead frame comprising an outer lead part, an inner lead part, and an electronic component mounting part that is used for mounting an electronic component, wherein a support lead part for supporting the electronic component mounting part from the outer lead part side is formed in the electronic component mounting part.

30. The method of producing a lead frame as defined in claim 29, comprising at least two support lead parts.

31. The method of producing a lead frame as defined in claim 29 or 30, wherein the inner lead part and an electronic component mounted on the electronic component mounting part are electrically connected to each other.

32. The method of producing a lead frame as defined in any one of claims 29 to 31, wherein the inner lead part, an electronic component mounted on the electronic component mounting part, and the support lead part are air-tightly sealed or sealed by a resin.

33. The method of producing a lead frame as defined in claim 32, wherein a lead frame part that is air-tightly sealed or sealed by a resin is not exposed for an exposure part that is exposed to an external environment in use in a part that is air-tightly sealed or sealed by a resin.

34. A method of producing an electronic device comprising a lead frame that is produced by the method of producing a lead frame as defined in any one of claims 19 to 33.

35. The method of producing an electronic device as defined in claim 34, wherein the electronic device is a sensor that is used for carrying out a fluid discrimination.

36. The method of producing an electronic device as defined in claim 35, wherein the exposure part is exposed to a fluid in the fluid discrimination.

37. The method of producing an electronic device as defined in claim 35 or 36, wherein the fluid discrimination is at least one discrimination of the fluid type discrimination, a concentration discrimination, the fluid existence or nonexistence discrimination, a fluid temperature discrimination, a flow rate discrimination, a fluid leakage discrimination, and a fluid level discrimination.

[Fig. 1]

[Fig. 2]

[Fig. 3]

```
┌─────────────────────┐
│  Frame acceptance   │  S1
└─────────────────────┘
          ↓
┌─────────────────────────┐
│ Resist printing and exposure │
└─────────────────────────┘
S2       ↓
┌─────────────────────┐
│    Ni plating (part)    │
└─────────────────────┘              ┌─────────────────────┐
S3       ↓                           │        Frame        │
┌─────────────────────┐              └─────────────────────┘  S5
│     Separation      │                        ↓
└─────────────────────┘              ┌─────────────────────┐
S4       ↓                           │     Die bonding     │
┌─────────────────────┐              └─────────────────────┘  S6
│    Au plating (part)   │                     ↓
└─────────────────────┘              ┌─────────────────────┐
         ↓                           │    Wire bonding     │
                                     └─────────────────────┘  S7
                                               ↓
                              S8     ┌─────────────────────┐
                                     │       Molding       │
                                     └─────────────────────┘
                              S9     ┌─────────────────────┐
                                     │      Diver cut      │
                                     └─────────────────────┘
                             S10     ┌─────────────────────┐
                                     │       Marking       │
                                     └─────────────────────┘
                                               ↓
                                     ┌─────────────────────┐
                                     │   Mold separation   │
                                     └─────────────────────┘
                                               ↓
                                     ┌─────────────────────┐
                                     │      Completed      │
                                     └─────────────────────┘
```

[Fig. 4]

[Fig. 5]

[Fig. 6]

[Fig. 7]

[Fig. 8]

EP 2 190 014 A1

[Fig. 9]

[Fig. 10]

(a)

(b)

(a)

[Fig. 11]

[Fig. 12]

[Fig. 13]

[Fig. 14]

[Fig. 15]

[Fig. 16]

[Fig. 17]

[Fig. 18]

[Fig. 19]

Temperature (°C)

[Fig. 20]

Temperature (°C)

[Fig. 21]

Temperature (°C)

[Fig. 22]

[Fig. 23]

[Fig. 24]

[Fig. 25]

[Fig. 26]

S101

Frame plating

S102

Die bonding

S103

Wire bonding

S104

Molding

S105

Diver cut

S106

Mold burr removing

S107

Exterior plating
(terminal part plating)

S108

Marking

S109

Mold separation

Completed

[Fig. 27]

## INTERNATIONAL SEARCH REPORT

| | International application No. |
|---|---|
| | PCT/JP2008/066606 |

**A. CLASSIFICATION OF SUBJECT MATTER**
*H01L23/50(2006.01)i*

According to International Patent Classification (IPC) or to both national classification and IPC

**B. FIELDS SEARCHED**

Minimum documentation searched (classification system followed by classification symbols)
H01L23/50

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2008 |
| Kokai Jitsuyo Shinan Koho | 1971-2008 | Toroku Jitsuyo Shinan Koho | 1994-2008 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>Y | JP 5-136309 A  (Mitsubishi Electric Corp.),<br>01 June, 1993 (01.06.93),<br>Par. Nos. [0007] to [0018]<br>(Family: none) | 1-8,19-26<br>9,27,28 |
| X<br>Y | JP 2-94657 A  (NEC Corp.),<br>05 April, 1990 (05.04.90),<br>Page 2, upper left column, line 9 to upper<br>right column, line 7<br>(Family: none) | 10-15,29-34<br>9,27,28 |
| A | JP 2005-84026 A  (Mitsui Mining & Smelting Co.,<br>Ltd.),<br>31 March, 2005 (31.03.05),<br>Par. Nos. [0009] to [0037]<br>& US 2007/0054409 A1     & EP 1669743 A1<br>& WO 2005/026710 A1     & CA 2538780 A | 16-18,35-37 |

☐ Further documents are listed in the continuation of Box C.     ☐ See patent family annex.

| | |
|---|---|
| \* Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>27 November, 2008 (27.11.08) | Date of mailing of the international search report<br>09 December, 2008 (09.12.08) |
|---|---|
| Name and mailing address of the ISA/<br>Japanese Patent Office | Authorized officer |
| Facsimile No. | Telephone No. |

Form PCT/ISA/210 (second sheet) (April 2007)

**EP 2 190 014 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 11153561 A
- JP 2006029956 A
- JP 2005337969 A